# EUROPEAN PATENT APPLICATION

(11) **EP 3 579 053 A1**
(43) Date of publication of application: **11.12.2019**
(21) Application number: 19151870.3
(22) Date of filing: 15.01.2019
(51) Int. Cl.: G03F 7/20, B33Y 30/00, B29C 64/124

(54) **3D PRINTING DEVICE AND FORMATION TANK THEREOF**

(30) Priority: 07.06.2018 CN 201810582473
(71) Applicant: XYZprinting, Inc., New Taipei City 22201 (TW); Kinpo Electronics, Inc., New Taipei City 22201 (TW)
(72) Inventor: LU, Kuan-Yi, 22201 New Taipei City (TW); CHEN, Chun-Jui, 22201 New Taipei City (TW); NI, Chih-Ming, 22201 New Taipei City (TW); HUANG, Chen-Fu, 22201 New Taipei City (TW); LEE, An-Hsiu, 22201 New Taipei City (TW); LIN, Tsai-Yi, 22201 New Taipei City (TW)
(74) Representative: 2K Patentanwälte Blasberg Kewitz & Reichel

(57) **Abstract**

A formation tank (10) includes a tank body (100) and a release film (200). The tank body (11) includes a bottom plate (100) and a tank wall (12). One face of the bottom plate (100) is an inner bottom surface (101), and at least one engagement structure (110) is formed on the inner bottom surface (101). The tank wall (12) protrudes from the inner bottom surface (101) and surrounds a periphery of the bottom plate (100). The release film (200) is attached on the inner bottom surface (101) and the release film (200) is mortise-and-tenon connected to the engagement structure (110). An engagement structure (110) is arranged on the bottom plate (100) to improve an engagement force between the bottom plate (100) and the release film (200). Accordingly, the release film (200) is prevented from being detached, and therefore durability of the release film (200) is also improved.

## Description

### BACKGROUND OF THE INVENTION

### Field of the Invention

The present disclosure relates to a stereolithography (SLA) device and, in particular, to a 3D printing device and a formation tank of the 3D printing device, wherein the formation tank has a release film.

### Description of Related Art

Stereolithography (SLA) is a 3D printing technology in which light (in most cases, ultraviolet) is radiated to liquid photosensitive resin in a formation tank so as to solidify the photosensitive resin on a formation platform. A single layer is solidified each time during formation of a desired 3D object. By moving the formation platform, a layer of photosensitive resin can be filled between the platform or a semi-finished object and the bottom of the formation tank. Then, ultraviolet is radiated to the layer of photosensitive resin to solidify it. This process is repeated for each layer of the desired 3D object until the 3D object is completely formed.

After one layer of photosensitive resin is solidified, it is removed from the bottom of the formation tank by moving the formation platform. In order to attach a semi-finished object on the formation platform and to detach the semi-finished object from the bottom of the formation tank when the platform moves, a silicon film attached on the bottom of the formation tank is used to reduce an attaching force between the photosensitive resin and the bottom of the formation tank. However, the silicon film bears a pulling force each time the photosensitive resin is pulled away from the bottom of the formation tank. As a result, the silicon film is easily detached or damaged and thereby needs to be replaced.

In view of this, the inventor studied various technologies and created an effective solution in the present disclosure.

### SUMMARY OF THE INVENTION

The present disclosure provides a formation tank having a release film and a 3D printing device having the formation tank.

The present disclosure provides a formation tank. The formation tank includes a tank body and a release film. The tank body includes a bottom plate and a tank wall. One face of the bottom plate is an inner bottom surface. At least one engagement structure is formed on the inner bottom surface, the tank wall protrudes from the inner bottom surface and surrounds a periphery of the bottom plate. The release film is attached onto the inner bottom surface and is engaged with the engagement structure.

In the formation tank, the engagement structure includes a hook portion, and the release film is engaged with the hook portion. A flow-directing conical hole communicating with the engagement structure is formed on the inner bottom surface of the bottom plate, and the release film is mortise-and-tenon connected to the engagement structure through the flow-directing conical hole. The engagement structure includes a protruding block which protrudes from the inner bottom surface and is engaged with the release film. The hook portion protrudes laterally from a side surface of the protruding block. The engagement structure includes a cavity recessed into the bottom plate from the inner bottom surface, and the release film is mortise-and-tenon connected to the cavity. The hook portion can protrude from an inner sidewall surface of the cavity. The cavity is an inverted conical hole. The other face of the bottom plate is an outer bottom surface opposite to the inner bottom surface, the cavity penetrates through the bottom plate, and an outer cover plate is disposed on the outer bottom surface to cover and close a bottom of the cavity. The engagement structure enables non-planar junction of the bottom plate and the release film.

A 3D printing device is provided in the present disclosure. The 3D printing device includes a tank body, a release film and a formation platform. The tank body includes a bottom plate and a tank wall. One face of the bottom plate is an inner bottom surface. At least one engagement structure is formed on the inner bottom surface. The tank wall protrudes from the inner bottom surface and surrounds a periphery of the bottom plate. The release film is attached onto the inner bottom surface. The release film is engaged with the engagement structure. The formation platform is suspended above the bottom plate and movable to ascend or descend with respect to the inner bottom surface.

In the 3D printing device, the engagement structure includes a hook portion, and the release film is engaged with the hook portion. A flow-directing conical hole communicating with the engagement structure is formed on the inner bottom surface of the bottom plate, and the release film is mortise-and-tenon connected to the engagement structure through the flow-directing conical hole. The engagement structure includes a protruding block which protrudes from the inner bottom surface and is engaged with the release film. The hook portion protrudes laterally from a side surface of the protruding block. The engagement structure includes a cavity recessed into the bottom plate from the inner bottom surface, and the release film is mortise-and-tenon connected to the cavity. The hook portion can protrude from an inner sidewall surface of the cavity. The cavity is an inverted conical hole. The other face of the bottom plate is an outer bottom surface opposite to the inner bottom surface, the cavity penetrates through the bottom plate, and an outer cover plate is disposed on the outer bottom surface to cover and close a bottom of the cavity. The engagement structure enables non-planar junction of the bottom plate and the release film.

In the 3D printing device and the formation tank thereof, the engagement structure in the bottom plate of the formation tank is used to improve an engagement force between the bottom plate and the release film. By this way, the release film is prevented from being detached when a solidified slice of a desired 3D object is pulled away from the release film.

### BRIEF DESCRIPTION OF THE DRAWINGS

The disclosure will become more fully understood from the detailed description and the drawings given herein below for illustration only, and thus does not limit the disclosure, wherein:
FIG. 1 is a schematic view illustrating a 3D printing device according to one embodiment of the present disclosure;
FIG. 2 is a perspective view illustrating a bottom plate of a formation tank in the 3D printing device according to one embodiment of the present disclosure;
FIGS. 3 and 4 are cross-sectional views illustrating an engagement structure in the 3D printing device; and
FIGS. 5 and 6 are schematic views illustrating examples of the engagement structure in the 3D printing device.

### DETAILED DESCRIPTION OF THE INVENTION

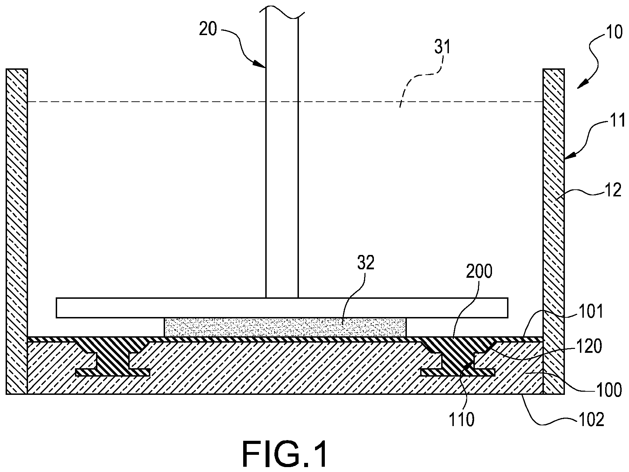

Referring to Fig. 1, a 3D printing device is provided in one embodiment of the present disclosure. The 3D printing device includes a formation tank 10 and a formation platform 20. The formation tank 10 receives liquid resin 31 inside. The formation platform 20 is suspended above a bottom plate 100 and is movable to ascend or descend with respect to an inner bottom surface 101. A single layer is solidified each time during formation of a desired 3D object. By moving the formation platform 20, a layer of liquid resin 31 can be filled between the formation platform 20 and the bottom of the formation tank 10 or between a solidified slice 32 (i.e. a semi-finished object) and the bottom of the formation tank 10. Then, ultraviolet is radiated to the layer of liquid resin 31 to solidify it into a solidified slice 32. After fabrication of one solidified slice 32 is completed, the solidified slice 32 is removed from the bottom of the formation tank 10 by moving the formation platform 20, and another layer of liquid resin 31 is filled between the solidified slice 32 and the bottom of the formation tank 10. This process is repeated for each layer of the desired 3D object until the 3D object is completely formed.

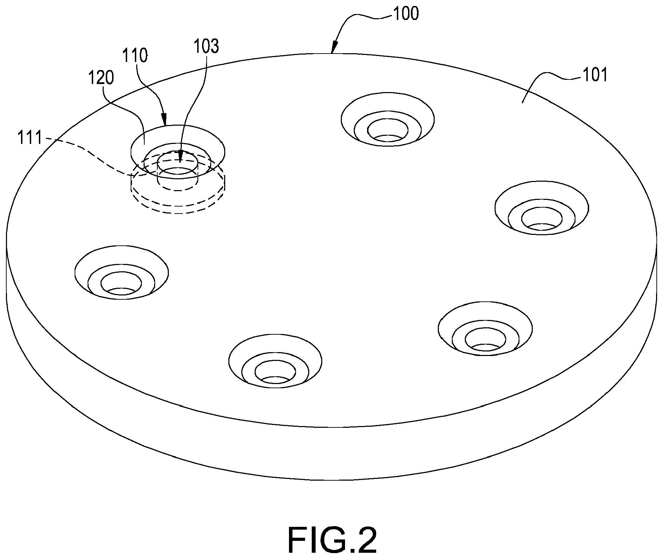

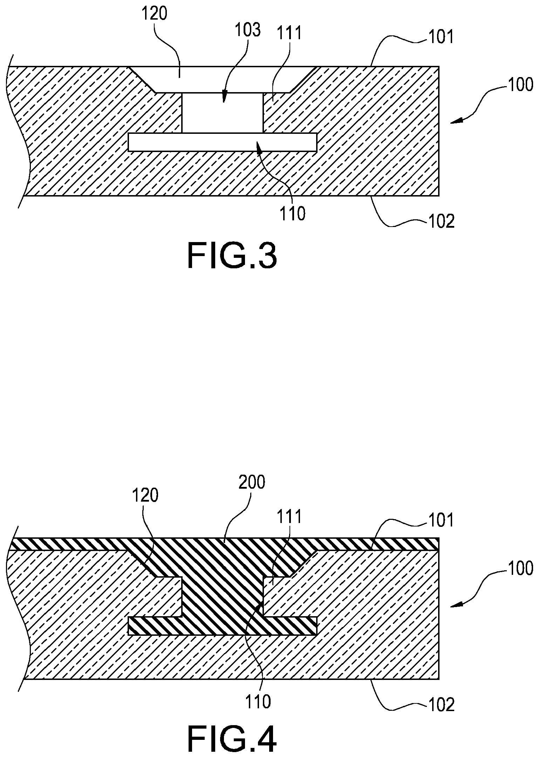

Referring to Figs. 2 to 4, in the present embodiment, the modeling thank 10 includes a tank body 11 and a release film 200 attached inside the tank body 11. The tank body 11 includes a bottom plate 100 and a tank wall 12. One face of the bottom plate 100 is an inner bottom surface 101. The other face of the bottom plate 100 is an outer bottom surface 102 opposite to the inner bottom surface 101. At least one engagement structure 110 is formed on the inner bottom surface 101 of the bottom plate 100. In the present embodiment, there are multiple same engagement structures 110 formed on the bottom plate 100. The engagement structure 110 enables non-planar junction of the bottom plate 100 and the release film 200. These engagement structures 110 are circularly arranged at equal intervals to provide an even engagement force in all directions. Although the present embodiment has multiple engagement structures 110, only one engagement structure 110 will be described as an example hereinafter for brevity. The tank wall 12 protrudes from the inner bottom surface 101 and surrounds a periphery of the bottom plate 100. The bottom plate 100 and the tank wall 12 together defines an interior space of the tank body 11, and the interior space is used for receiving the liquid resin 31.

The release film 200 is attached on the inner bottom surface 101 of the bottom plate 100 to reduce an attaching force between the solidified slice 32 and the bottom of the formation tank 10. The release film 200 is engaged with the engagement structure 110. In detail, the release film 200 is made of silicon. In fabrication of the release film 200, liquid silicon is filled into the tank body 11 to cover the inner bottom surface 101 of the bottom plate 100 with a layer of liquid silicon. After the layer of liquid silicon is solidified, the release film 200 is formed. In the present embodiment, the engagement structure 110 includes a cavity 103 recessed into the bottom plate 100 from the inner bottom surface 101, and the release film 200 is mortise-and-tenon connected to the cavity 103 and thereby engaged with the bottom plate 100. The engagement structure 110 includes a hook portion 111, and the release film 200 is engaged with the hook portion 111. In the present embodiment, the hook portion 111 protrudes from an inner sidewall surface of the cavity 103 to decrease a diameter of a middle section of the cavity 103. To be specific, after the liquid silicon is filled into the tank body 11, the liquid silicon covers the inner bottom surface 101 of the bottom plate 100 and is filled into the engagement structure 110 to cover the hook portion 111, and the release film 200 is then engaged with the hook portion 111 after the liquid silicon is solidified.

In the present embodiment, a flow-directing conical hole 120 is recessed into the bottom plate 100 from the inner bottom surface 101. In detail, the flow-directing conical hole 120 has a cone shape, tapering downward. A tip of the flow-directing conical hole 120 communicates with the cavity 103 of the engagement structure 110. When the liquid silicon is filled into the tank body 11, the flow-directing conical hole 120 can guide the liquid silicon to fill in the cavity 103 of the engagement structure 110 and to cover the hook portion 111. As a result, the solidified release film 200 is mortise-and-tenon connected to the engagement structure 110 through the flow-directing conical hole 120.

Referring to Fig. 1, in the 3D printing device and the formation tank 10 thereof, the engagement structure 110 is disposed on the bottom plate 100 of the formation tank 10, so an engagement force between the bottom plate 100 and the release film 200 is enhanced. Consequently, when the solidified slice 32 of the semi-finished object is pulled away from the release film 200, the release film 200 is prevented from being detached from the formation tank 10, thereby improving durability of the release film 200. The engagement structure 110 enables non-planar junction of the bottom plate 100 (more specifically, the inner bottom surface 101) and the release film 200. In other words, the engagement structure 110 does not cause regular plane-to-plane junction between the bottom plate 100 and the release film 200, so that the engagement force between the bottom plate 100 and the release film 200 is improved. The engagement structure 110 can be a structure recessed into or protrudes from the inner bottom surface 101. Due to the engagement structure 110, the inner bottom surface 101 is not a continuous flat surface, thereby enabling non-planar junction of the bottom plate 100 (more specifically, the inner bottom surface 101) and the release film 200. As shown in the cross-sectional drawings, a cross-sectional width of the engagement structure 110 is not a constant value, and it varies depending on a distance from the inner bottom surface 101 to a cross-sectional portion of the engagement structure 110 recessed into or protrudes from the inner bottom surface 101. In the present embodiment, the cross-sectional width increases as the cross-sectional portion of the engagement structure 110 is away from the inner bottom surface 101, so as to improve the engagement force between the bottom plate 100 and the release film 200; however, the present disclosure is not limited in this regard.

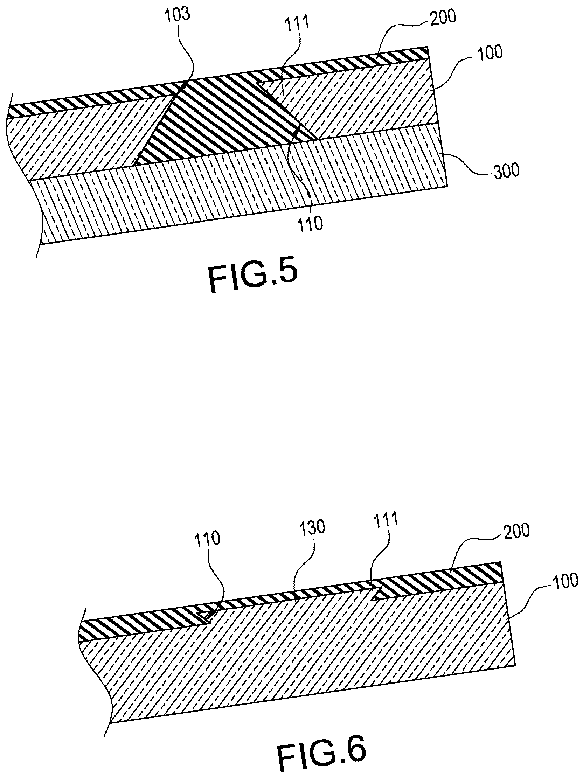

Please refer to Fig. 5 illustrating the hook portion 111 according to another embodiment. A top rim of the cavity 103 protrudes inwardly to form the hook portion 111. Different fabrication methods can be chosen to make different types of cavities 103. In the foregoing embodiment, the cavity 103 is a blind hole. However, the cavity 103 can also be a through hole penetrating through the bottom plate 100, and an outer cover plate 300 is disposed on the outer bottom surface 102 to cover and close a bottom of the cavity 103.

Referring to Fig. 6, the engagement structure 110 also can protrude from the bottom plate 100. The engagement structure 110 can include a protruding block 130 which protrudes from the inner bottom surface 101 and is engaged with the release film 200 to improve the engagement force between the bottom plate 100 and the release film 200. The hook portion 111 protrudes laterally from a side surface of the protruding block 130 so as to properly engage the release film 200. The release film 200 is made of silicon. In fabrication of the release film 200, the liquid silicon is filled into the tank body 11 to cover the inner bottom surface 101 of the bottom plate 100 and also cover the protruding block 130. Then, the liquid silicon is solidified into the release film 200 to make the protruding block 130 engaged in the release film 200.

## Claims

1. A formation tank (10), comprising:
a tank body (11) including a bottom plate (100) and a tank wall (12), one face of the bottom plate (100) being an inner bottom surface (101), at least one engagement structure (110) being formed on the inner bottom surface (101), the tank wall (12) protruding from the inner bottom surface (101) and surrounding a periphery of the bottom plate (100); and
a release film (200) disposed on the inner bottom surface (101), the release film (200) being engaged with the engagement structure (110).

2. The formation tank according to claim 1, wherein the engagement structure (110) includes a hook portion (111), and the release film (200) is engaged with the hook portion (111).

3. The formation tank according to claim 2, wherein the engagement structure (110) includes a protruding block (130) protruding from the inner bottom surface (101) and engaged with the release film (200), the hook portion (111) protrudes laterally from a side surface of the protruding block (130).

4. The formation tank according to claim 2, wherein the engagement structure (110) includes a cavity (103) recessed into the bottom plate (100) from the inner bottom surface (101), and the release film (200) is mortise-and-tenon connected to the cavity (103).

5. The formation tank according to claim 4, wherein the hook portion (111) protrudes from an inner sidewall surface of the cavity (103), the cavity (103) is an inverted conical hole.

6. The formation tank according to claim 4, wherein the other face of the bottom plate (100) is an outer bottom surface (102) opposite to the inner bottom surface (101), the cavity (103) penetrates through the bottom plate (100), and an outer cover plate (300) is disposed on the outer bottom surface (102) to cover and close a bottom of the cavity (103).

7. The formation tank according to claim 1, wherein a flow-directing conical hole (120) communicating with the engagement structure (110) is formed on the inner bottom surface (101) of the bottom plate (100), and the release film (200) is mortise-and-tenon connected to the engagement structure (110) through the flow-directing conical hole (120).

8. The formation tank according to claim 1, wherein the engagement structure (110) enables non-planar junction of the bottom plate (100) and the release film (200).

9. A 3D printing device, comprising:
a tank body (11) including a bottom plate (100) and a tank wall (12), one face of the bottom plate (100) being an inner bottom surface (101), at least one engagement structure (110) being formed on the inner bottom surface (101), the tank wall (12) protruding from the inner bottom surface (101) and surrounding a periphery of the bottom plate (100);
a release film (200) disposed on the inner bottom surface (101), the release film (200) being engaged with the engagement structure (110); and
a formation platform (20) suspended above the bottom plate (100) and movable to ascend or descend with respect to the inner bottom surface (101).

10. The 3D printing device according to claim 9, wherein the engagement structure (110) includes a hook portion (111), and the release film (200) is engaged with the hook portion (111).

11. The 3D printing device according to claim 10, wherein the engagement structure (110) includes a protruding block (130) which protrudes from the inner bottom surface (101) and is mortise-and-tenon connected to the release film (200), the hook portion (111) protrudes laterally from a side surface of the protruding block (130).

12. The 3D printing device according to claim 10, wherein the engagement structure (110) includes a cavity (103) recessed into the bottom plate (100) from the inner bottom surface (101), and the release film (200) is mortise-and-tenon connected to the cavity (103).

13. The 3D printing device according to claim 12, wherein the hook portion (111) protrudes from an inner sidewall surface of the cavity (103), the cavity (103) is an inverted conical hole.

14. The 3D printing device according to claim 12, wherein the other face of the bottom plate (100) is an outer bottom surface (102) opposite to the inner bottom surface (101), the cavity (103) penetrates through the bottom plate (100), and an outer cover plate (300) is disposed on the outer bottom surface (102) to cover and close a bottom of the cavity (103).

15. The 3D printing device according to claim 9, wherein a flow-directing conical hole (120) communicating with the engagement structure (110) is formed on the inner bottom surface (101) of the bottom plate (100), and the release film (200) is mortise-and-tenon connected to the engagement structure (110) through the flow-directing conical hole (120).
